# EUROPÄISCHE PATENTSCHRIFT

(11) **EP 0 638 508 B1**
(45) Veröffentlichungstag und Bekanntmachung des Hinweises auf die Patenterteilung: **03.03.1999**
(21) Anmeldenummer: 94110951.4
(22) Anmeldetag: 14.07.1994
(51) Int. Cl.: B66B 1/46, H03K 17/94

(54) **Druckknopfelement**
Push-button element
Elément bouton-poussoir

(30) Priorität: 12.08.1993 US 105059
(43) Veröffentlichungstag der Anmeldung: 15.02.1995
(73) Patentinhaber: INVENTIO AG, CH-6052 Hergiswil NW (CH)
(72) Erfinder: Shea, Timothy S., Morristown, New Jersey 07960 (US); Sandhou, Surjit S., Neshanic Station, New Jersey 08853 (US)

(56) Entgegenhaltungen:
- WO-A-87/04878
- DE-B- 1 762 674
- US-A- 4 179 594
- US-A- 4 570 754

## Beschreibung

Elektronisches Druckknopfelement als Ruf- und Signalgeber in Aufzugssteuerungen für den Einbau mit rückseitiger Befestigung in Bedienungstableaux auf Stockwerken und in Aufzugskabinen bestehend aus Druckknopfführung, Trägerplatte, optischer Quittung und Elektronikteil.

Druckknopfelemente der obgenannten Art sind in verschiedenen Varianten bekannt. Einerseits bezüglich des verwendeten aktiven Elementes und anderseits bezüglich der konstruktiven Ausgestaltung. Als aktives Element bezeichnen wir jenes Bauteil, welches bei einer mechanischen Krafteinwirkung ein elektrisches Signal abgibt oder mindestens seine elektrischen Eigenschaften verändert. Bauteile der ersten Art sind beispielsweise jene, welche nach dem Piezo-Prinzip funktionieren. Bei Krafteinwirkung wird vom Piezo-Kristall ein Spannungspuls abgegeben. Bauteile der zweiten Art verändern bei Krafteinwirkung ihre elektrischen Eigenschaften in dem Sinne, dass beispielsweise die Kapazitätswerte, die Induktivität oder der ohmsche Widerstand eine Wertänderung erfährt.

Es ist bekannt, dass solche Elemente für die Konstruktion prellfreier Schalter verwendet werden. Zudem wird ein weiterer Vorteil ausgenützt, indem Drucktaster mit extrem kurzem oder gar keinem Betätigungshub realisiert werden können.

Die amerikanische Patentschrift Nr. 4,805,739 beschreibt ein Druckknopfelement für Aufzugssteuertableaux, welches nach dem Piezo-Prinzip funktioniert. Ohne feststellbaren mechanischen Betätigungweg wird beim Drücken auf eine membranartige Betätigungsscheibe ein an der Rückseite dieser Scheibe angebrachtes Piezoelement aktiviert und der daraus resultierende Spannungspuls in einem Elektronikkreis zum Steuersignal verarbeitet. Ein tranparentes Gehäuse leitet das durch LED siganlisierte Quittungssignal an einen Leuchtring auf der Tableau-Oberfläche.

Es wird von einer Bedienungsperson allenfalls als Mangel empfunden, wenn eine Schalterbetätigung keinen Betätigungsweg zur Folge hat.

Ferner beschreibt ein weiteres amerikanisches Patent Nr. 4,489,302 ein auf Druck sich elektrisch veränderndes Element. Es handelt sich hierbei um ein mehrlagiges Halbleiterelement, welches, abhängig vom Betätigungsweg, seinen elektrischen Widerstand verändert. Eine konstruktive Ausgestaltung zu einem praktisch verwendbaren Druckknopfelement ist nicht dargestellt.

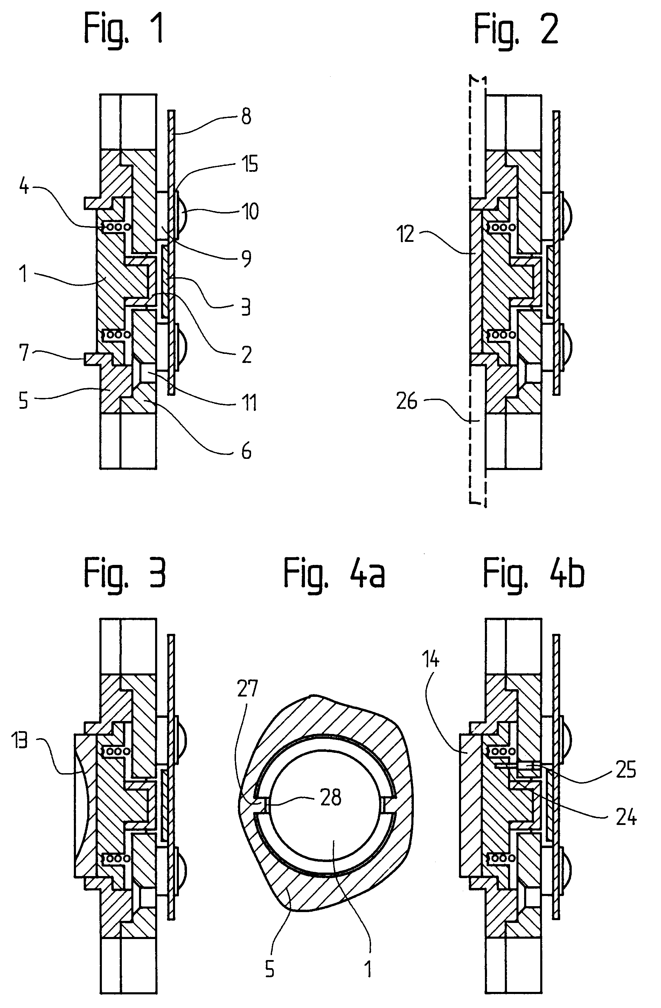

Die deutsche Offenlegungsschrift DE 37 03 666 zeigt die Anwendung eines druckabhängigen Widerstandes für einen Rufgeber mit LED-Quittung. Die dargestellte Lösung für ein Druckknopfelement in der Fig. 3 ist jedoch nur symbolhaft und kann nicht als verwendbare Konstruktion gelten.

Der vorliegenden Erfindung liegt die Aufgabe zugrunde, auf der Basis eines kontaktlosen Elementes ein vollständiges Druckknopfelement als Rufgeber mit optischer Quittung für eine Aufzugssteuerung zu schaffen, wobei ein bestimmter Betätigungsweg, eine einfache, kostengünstige Konstruktion und die Kombination mit verschiedenen Design-Elementen erwünscht ist.

Diese Aufgabe wird durch die in den Ansprüchen gekennzeichnete Erfindung gelöst.

Die Vorteile der vorliegenden Erfindung sind darin zu sehen, dass eine Person bei einer Druckknopfbetätigung durch den realisierten Betätigungsweg eine für sie befriedigende Reaktion des Druckknopfelementes erfährt. Die erfindungsgemässe Konstruktion kann in einer Variante als vandalensicher gelten, weil das Druckknopfelement keine vorstehenden Teile aufweist und vollständig bündig mit der Tableauoberfläche ist. Ferner können verschiedene, dem Design des Tableau's angepasste Druckscheiben eingesetzt werden. Die erfindungsgemässe Konstruktion erlaubt ferner ein problemloses Auswechseln einer allenfalls defekten Elektronik ohne Demontage des Druckknopfelementes.

In den Zeichnungen sind Ausführungsbeispiele dargestellt und es zeigen
- Fig.1: einen Querschnitt des Druckknopfelementes,
- Fig.2: das Druckknopfelement mit bündiger, flacher Druckscheibe,
- Fig.3: das Druckknopfelement mit vorstehender, mittig vertiefter Druckscheibe,
- Fig.4a: einen Querschnitt des Druckknopfelemntes im Bereich der internen Verdrehsicherung,
- Fig.4b: das Druckknopfelement mit vorstehender, flacher Druckscheibe
- Fig.5: eine Vorderansicht des Druckknopfelementes,
- Fig.6: ein Rückansicht des Druckknopfelementes und
- Fig.7: einen Schaltkreis der Druckknopfelektronik.

Im Querschnit in der Fig. 1 ist mit 1 ein Stösselelement bezeichnet. Das Stösselelement 1 weist an seiner Rückseite eine ringförmige Nut auf in welcher sich eine Druckfeder 4 befindet. Das Stösselelement 1 kann einen begrenzten horizontalen Weg ausführen in der Führung einer Leuchtringplatte 5. Das Material der Leuchtringplatte 5 ist glasklartransparent und kann vorzugsweise aus Lexan oder Acryl gefertigt sein.
Der kreisförmige Vorsprung links an der Leuchtringplatte 5 ist der mit 7 bezeichnete Leuchtring selbst, welcher im einegebauten Zustand des Druckknopfelementes von der Frontseite des Tableau's als einziges Teil der Leuchtringplatte 5 sichtbar bleibt. Als linksseitiger Bewegungsanschlag für das Stösselelement 1 dient ein Absatz in der Leuchtringplatte 5 und ein vorstehender Rand an der rechten Seite des Stösselelementes 1. Als rechtsseitiger Bewegungsanschlag wirkt die mit der Leuchtringplatte 5 zusammengefügte Reflektorplatte 6. Das Stösselelement 1 weist rechts in der Mitte einen zapfenförmigen Fortsatz auf, welcher mit einer elastischen Druckkappe 5 bedeckt ist. Das Stösselelement 1 wird durch die Druckfeder 4, welche sich rechts auf die Reflektorplatte 6 abstützt, permanent nach links an den Anschlag in der Leuchtringplatte 5 gedrückt. Die Reflektorplatte 6 weist kreisförmig angeordnete Senkbohrungen 11 auf, welche der Fassung von nicht dargestellten LED's dienen. Die Reflektorplatte 6 besteht vorzugsweise aus weiss eingefärbtem Lexan oder einem anderen vergleichbaren Kunsrstoff.

An der Rückseite der Reflektorplatte 6 ist, distanziert mit Distanzscheiben 9 und befestigt mit Schrauben 10 und Unterlagscheiben 15, ein Elektronikprint 8 angeordnet.
Auf dem Elektronikprint 8 ist mit 3 ein auf mechanischen Druck reagierender Widerstand 3, in der Folge FSR (Force Sensitive Resistor) genannt, angedeutet. Der FSR 3 ist direkt hinter der der Druckkappe 2 des Stösselelementes 1 angeordnet und wird bei Betätigung des Druckknopfelementes mechanisch druckbelastet.

Das erfindungsgemässe Druckknopfelement kann, wie bereits bei den Vorteilen erwähnt, mit verschiedenen Druckscheiben versehen werden.

Gemäss der Fig.2 ist eine flache, mit der Tableaufläche bündige Druckscheibe 12 eingesetzt. Diese Variante des Druckknopfelementes kann als weitgehend vandalenresistent gelten, weil keine Vorspünge zum Ansetzen eines Werkzeuges vorhanden sind.

Gemäss der Fig. 3 ist eine vorstehende mit einer Mulde versehene Druckplatte 13 und gemäss der Fig.4b eine ebenfalls vorstehende aber flache Druckplatte 14 eingesetzt.

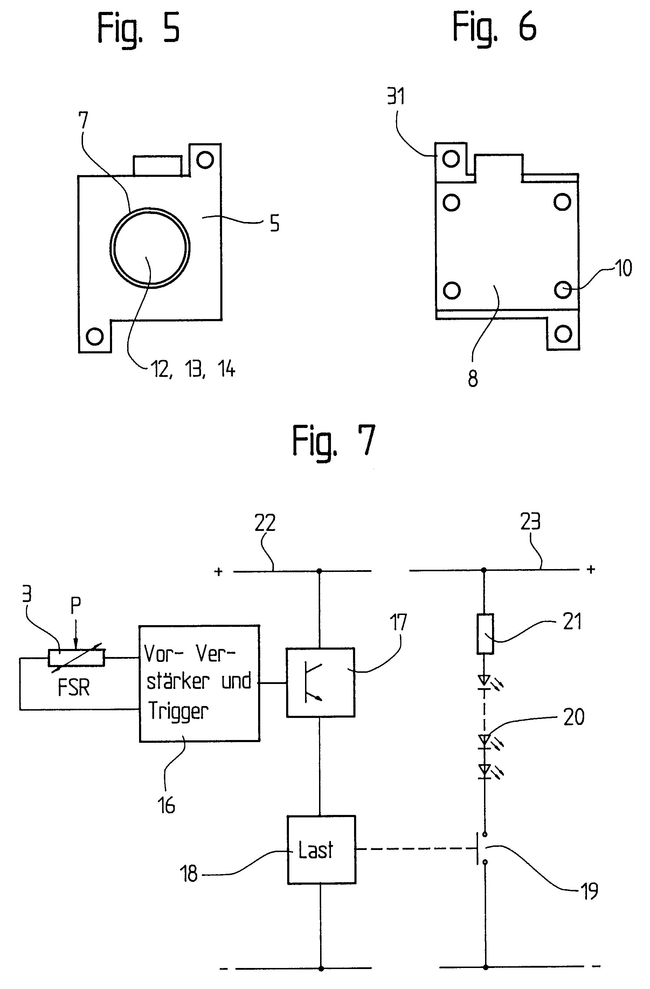

In der Frontansicht der Fig.5 ist die Kontur der Leuchtringplatte 5, sowie der Leuchtring 7 selbst sichtbar. Mit 12,13 und 14 wird auf die verschiedenen, vorgängig beschriebenen Druckplatten hingewiesen.

In der Fig.6 ist die Kontur des Elektronikprintes 8 sichtbar. Der obere rechteckige Fortsatz dient einer internen Steckverbindung.

In der Fig.7 ist ein vereinfachtes Schaltschema dargestellt.

Verbunden mit den Potentialen einer Speisespannung 22 ist ein Schalttransistor 17 und in Serie eine Last 18 dargestellt. Die Last 18 kann eine Relais- oder eine Schützspule sein. Der Schalttransistor 17 wird von einem Trigger/Vorverstärker 16 ausgesteuert, wenn sich der eingangs angeschlossene Widerstand FSR 3 bei Druckeinwirkung entsprechend verändert.

In einem zweiten, galvanisch getrennten Spannungskreis 23 ist die Quittungsschaltung dargestellt. Ein Kontakt 19 der Last 18 schliesst diesen Kreis, womit Strom durch eine Anzahl in Serie geschalteter LED's 20 und einen ebenfalls in Serie geschalteten Vorwiderstand 21 fliesst und so ein optisches Quittungssignal entsteht.

Die Funktionsweise der erfindungsgemässen Konstruktion ist mit der Teilebeschreibung weitgehend erklärt. Diesbezüglich sind aber noch einige Einzelheitenzu erwähnen.

Das erfindungsgemässe Druckknopfelement kann, wie in Fig.2 angedeutet, an der Rückseite an einer Tableauplatte 26 in bekannter Weise befestigt werden und der Leuchtring 7 der Leuchtringplatte 5 ergibt einen bündigen Abschluss mit der Tableauplatte 26.

Der verwendete FSR 3 verändert seinen ohm'schen Widerstand bei Krafteinwirkung beispielweise im Verhältnis 1000:1, so dass ein 1Megohm-FSR-Widerstand 3 bei Betätigung des Druckknopfes noch 100 Ohmm aufweist. Diese grosse Widerstandsänderung wird in der Schaltung dahin genutzt, indem der FSR 3 in Serie mit einem weiteren aber konstanten, nicht dargestellten Widerstand einen Spannungsteiler bildet, dessen Mittelabgriff zwischen den beiden Widerständen über einen ebenfalls nicht dargestellten Basiswiderstand in bekannter Weise einen Vorverstärker/Trigger 16 aussteuert und dieser dann, wie bereits erwähnt, den Schalttransistor 17 in den leitenden Zustand bringt, womit die Last 18 eingeschaltet wird und ein Lastkontakt 19 den Quittungskreis schliesst.

Bei Nichtbetätigung des Druckknopfes ist der FSR 3 nicht nur mechanisch völlig unbelastet, sondern sogar durch einen kleinen Luftspalt zwischen FSR 3 und der Oberfläche der Druckkappe 2 des Stösselelementes 1 von diesem distanziert. Diese Disposition hat den Vorteil, dass die Konstruktion einerseits weniger abhängig von Masstoleranzen ist und anderseits ein temperaturbedingtes Verbiegen von Teilen, beispielsweise durch Hitzeeinwirkung bei Brandfall, keine unerwünschte und gefährliche Kommandogabe zur Folge hat.

Ein weiterer Effekt der erfindungsgemässen Konstruktion besteht darin, dass durch die internen mechanischen Anschläge beim Stösselelement 1 und der Reflektorplatte 6 nur ein begrenzter Weg des Stösselelementes möglich ist. Weil nun noch der zapfenförmige Fortsatz des Stösselelementes 1 mit einer elastischen Druckkappe 2 überdeckt ist und die Distanzscheiben 9 dementsprechend dimensioniert sind, kann eine maximal zulässige Druckkraft auf den FSR 3, auch bei grösster Krafteinwirkung auf das Druckknopfelement, nicht überschritten werden.

Das Prinzip der auswechselbaren Druckscheiben 12,13, und 14 erlaubt eine weitgehende Anpassung an das Tableaudesign, an Kundenwünsche und an Spezialfunktionen. Die Anzahl der auswechselbaren Druckscheiben ist nicht auf die drei dargestellten Beispiele 12, 13 und 14 begrenzt. Wird das Druckknopfelement selbst beschriftet und werden transparente Druckscheiben verwendet, kann die Beschriftung als bedruckte Zwischenlage zwischen Druckscheibe 12, 13 und 14 Stösselelement 1 erfolgen. Für diesen Fall wird im Druckknopfelement, wie in der Fig.4b dargestellt, eine Verdrehsicherung, mittels eines Stiftes 24 im Stösselelement 1 und einer Führungsbohrung 25 in der Reflektorplatte 6, vorgesehen.

Es ist ferner für Sicherheitsschalter mit vorgeschriebener galvanischer Trennung möglich, aufgrund des realisierten Betätigungsweges, mit der gleichen Basiskonstruktion einen Mikroschalter zu betätigen. Der Mikroschalter wird dann in einer nicht dargestellten Trägerplatte mit der gleichen Kontur des Elektronikprintes 8 angeordnet und die Trägerplatte mit den gleichen Befestigungselementen 9, 10 und 15 mit dem Druckknopfelement mechanisch verbunden.

Das Stösselelement 1 ist, gemäss Fig. 4a, in einer weiteren Art gegen Verdrehung gesichert, indem am Stösselelement 1 mindestens eine, am äusseren Rand ausgenommene Nut 28 vorhanden ist, in welche mindestens ein, intern in der Leuchtringplatte 5 ausgeformter Nocken 27 eingreift.

Mit der erfindungsgemässen mechanischen Basiskonstruktion ist es möglich, beliebige, auf mechanischen Druck reagierende Elemente zu verwenden. So kann beispielsweise auch eine Widerstandsbrücke mit Dehnungsmessstreifen auf dem Elektronikprint 8 angeordnet sein und durch dessen elastische Verformung infolge Druck auf den Print eine Steuerfunktion ausüben.

## Patentansprüche

1. Elektronisches Druckknopfelement als Ruf- und Signalgeber in Aufzugssteuerungen für den Einbau mit rückseitiger Befestigung in Bedienungstableaux auf Stockwerken und in Aufzugskabinen, bestehend aus Druckknopfführung (5), Trägerplatte, optischer Quittung und Elektronikteil (8) dadurch gekennzeichnet, dass das Druckknopfelement ein in einer Führung begrenzt bewegbares, mit einer elastischen Druckkappe (2) versehenes, auf ein drucksensitives Element (3) eine bei Betätigung einen tolerierbaren Maximalwert nicht überschreitbare Druckkraft ausübendes, mit verschiedenen Druckscheiben (12,13,14) kombinierbares Stösselelement (1) aufweist.

2. Elektronisches Druckknopfelement nach Anspruch 1, dadurch gekennzeichnet, dass die bei Betätigung das drucksensitive Element berührende Oberfläche der Druckkappe (2) mittels einer Druckfeder (4) im Stösselelement (1) bei Nichtbetätigung des Druckknopfes eine das drucksensitive Element nicht berührende und von diesem distanzierte Lage aufweist.

3. Elektronisches Druckknopfelement nach Anspruch1, dadurch gekennzeichnet, dass das Druckknopfelement eine zwischen Druckscheibe (12,13,14) und Stösselelement (1) einsetzbare Beschriftungsmöglichkeit aufweist.

4. Elektronisches Druckknopfelement nach Anspruch 1, dadurch gekennzeichnet, dass als drucksensitives Element ein FSR (3) vorhanden ist.

5. Elektronisches Druckknopfelement nach Anspruch 1, dadurch gekennzeichnet, dass als drucksensitives Element ein Dehnungsmessstreifen vorhanden ist.

6. Elektronisches Druckknopfelement nach Anspruch 1, dadurch gekennzeichnet, dass als drucksensitives Element ein Mikroschalter vorhanden ist.

7. Elektronisches Druckknopfelement nach Anspruch 1, dadurch gekennzeichnet, dass eine Verdrehsicherung mittels mindestens einer Nut (28) im Stösselelement (1) und mindestens einem in die Nut (28) eingreifenden Nocken (27) in der Leuchtringplatte (5) vorhanden ist.

8. Elektronisches Druckknopfelement nach einem der vorhergehenden Ansprüche, dadurch gekennzeichnet, dass als Verdrehsicherung ein Stift (24) in der Leuchtringplatte (5) und eine, den Stift (24) aufnehmende Bohrung (25) in der Reflektorplatte (6) vorhanden ist.

9. Elektronisches Druckknopfelement nach einem der vorhergehenden Ansprüche, dadurch gekennzeichnet, dass eine Leuchtringplatte (5) eine dem Stösselelement (1) als Führung dienende Ausbildung aufweist.

10. Elektronisches Druckknopfelement nach einem der vorhergehenden Ansprüche, dadurch gekennzeichnet, dass die Leuchtringplatte (5) und die Reflektorplatte (6) eine dem Stösselelement (1) einen begrenzten Weg ermöglichende Ausbildung aufweisen.

## Claims

1. Electronic pushbutton element as call and signal transmitter in lift controls for installation with rear-side fastening in control panels at storeys and in lift cages, consisting of pushbutton guide (5), carrier plate, optical acknowledgement and electronic part (8), characterised in that the pushbutton element comprises a plunger element (1) which s capable of limited movement in a guide, is provided with a resilient pressure cap (2), exerts on actuation a pressure force not exceeding an acceptable maximum value on a pressure-sensitive element (3) and is able to be combined with different press discs (12, 13, 14).

2. Electronic pushbutton element according to claim 1, characterised in that the surface of the pressure cap (2) which on actuation contacts the pressure-sensitive element has on non-actuation of the pushbutton and by means of a compression spring (4) in the plunger element (1) a position which does not contact the pressure-sensitive element and is spaced therefrom.

3. Electronic pushbutton element according to claim 1, characterised in that the pushbutton has a legend possibility insertable between press disc (12, 13, 14) and plunger element (1).

4. Electronic pushbutton element according to claim 1, characterised in that a force-sensitive resistor (3) is present as the pressure-sensitive element.

5. Electronic pushbutton element according to claim 1, characterised in that a strain-measuring strip is present as the pressure-sensitive element.

6. Electronic pushbutton element according to claim 1, characterised in that a microswitch is present as the pressure-sensitive element.

7. Electronic pushbutton element according to claim 1, characterised in that a rotational securing by means of at least one groove (28) in the plunger element (1) and at least one dog (27), which engages in the groove (28), in the illuminating ring plate (5) is present.

8. Electronic pushbutton element according to one of the preceding claims, characterised in that as securing against rotation a pin (24) is present in the illuminating ring plate (5) and a bore (25), which receives the pin (24), is present in the reflector plate (6).

9. Electronic pushbutton element according to one of the preceding claims, characterised in that an illuminating ring plate (5) has a construction serving the plunger element (1) as guide.

10. Electronic pushbutton element according to one of the preceding claims, characterised in that the illuminating ring plate (5) and the reflector plate (6) have a construction making a limited travel possible for the plunger element (1).

## Revendications

1. Elément électronique formant bouton-poussoir servant d'émetteur d'appels et de signaux dans des commandes d'ascenseurs pour un montage avec une fixation arrière dans des tableaux de commande, aux étages ou dans les cabines d'ascenseurs, composé d'un guide de bouton-poussoir (5), d'une plaque de support, d'un accusé de réception optique et d'un composant électronique (8), caractérisé en ce que l'élément formant bouton-poussoir comporte un élément formant coulisseau (1) qui présente une mobilité limitée dans un guide, qui est pourvu d'une calotte de pression élastique (2), qui exerce sur un élément sensible à la pression (3) une pression ne pouvant pas dépasser une valeur maximale tolérable lors de l'actionnement, et qui est apte à être combiné avec différentes plaques de pression (12, 13, 14).

2. Elément électronique formant bouton-poussoir selon la revendication 1, caractérisé en ce que lorsque le bouton-poussoir n'est pas actionné, la surface de la calotte de pression (2) qui touche l'élément sensible à la pression lors de l'actionnement présente, grâce à un ressort de compression (4) prévu dans l'élément formant coulisseau (1), une position dans laquelle il ne touche pas l'élément sensible à la pression mais est espacé de celui-ci.

3. Elément électronique formant bouton-poussoir selon la revendication 1, caractérisé en ce que l'élément formant bouton-poussoir présente une possibilité d'inscription entre la plaque de pression (12, 13, 14) et l'élément formant coulisseau (1).

4. Elément électronique formant bouton-poussoir selon la revendication 1, caractérisé en ce qu'il est prévu comme élément sensible à la pression une résistance FSR (sensible à une force) (3).

5. Elément électronique formant bouton-poussoir selon la revendication 1, caractérisé en ce qu'il est prévu comme élément sensible à la pression une jauge extensométrique.

6. Elément électronique formant bouton-poussoir selon la revendication 1, caractérisé en ce qu'il est prévu comme élément sensible à la pression un microrupteur.

7. Elément électronique formant bouton-poussoir selon la revendication 1, caractérisé en ce qu'il est prévu une protection à l'encontre d'une rotation grâce à au moins une rainure (28) prévue dans l'élément formant coulisseau (1), et à au moins une saillie (27) de la plaque annulaire lumineuse (5), qui pénètre dans la rainure (28).

8. Elément électronique formant bouton-poussoir selon l'une des revendications précédentes, caractérisé en ce qu'il est prévu comme protection à l'encontre d'une rotation une tige (24) prévue dans la plaque annulaire lumineuse (5), et un perçage (25) dans la plaque de réflecteur (6), qui reçoit la tige (24).

9. Elément électronique formant bouton-poussoir selon l'une des revendications précédentes, caractérisé en ce qu'une plaque annulaire lumineuse (5) présente une configuration qui sert de guidage à l'élément formant coulisseau (1).

10. Elément électronique formant bouton-poussoir selon l'une des revendications précédentes, caractérisé en ce que la plaque annulaire lumineuse (5) et la plaque de réflecteur (6) présentent une forme qui permet à l'élément formant coulisseau (1) d'avoir une course limitée.
